# EUROPÄISCHE PATENTANMELDUNG

(11) **EP 4 220 706 A1**
(43) Veröffentlichungstag der Anmeldung: **02.08.2023**
(21) Anmeldenummer: 22154511.4
(22) Anmeldetag: 01.02.2022
(51) Int. Cl.: H01L 23/373, H01L 23/34

(54) **ANORDNUNG FÜR EINE HALBLEITERANORDNUNG MIT MINDESTENS EINEM PASSIVEN BAUELEMENT UND EINEM SUBSTRAT**

(71) Anmelder: Siemens Aktiengesellschaft, 80333 München (DE)
(72) Erfinder: Lasch, Markus, 81927 München (DE); Lorz, Roland, 91341 Röttenbach (DE); Pfeifer, Markus, 90455 Nürnberg (DE); Stegmeier, Stefan, 81825 München (DE); Weisbrod, Erik, 81369 München (DE); Werner, Ronny, 90429 Nürnberg (DE); Zeyß, Felix, 93059 Regensburg (DE)
(74) Vertreter: Siemens Patent Attorneys

(57) **Zusammenfassung**

Die Erfindung betrifft eine Anordnung (2) für eine Halbleiteranordnung (50) mit mindestens einem passiven Bauelement (4) und einem Substrat (6), wobei das Substrat (6) eine dielektrische Materiallage (8) und eine auf der dielektrische Materiallage (8) angeordnete erste Metallisierung (10) aufweist. Um den Bauraum der Anordnung (2) zu verringern und eine verbesserte Entwärmung zu ermöglichen, wird vorgeschlagen, dass das passive Bauelement (4) vollständig in einer Aussparung (14) der ersten Metallisierung (10) angeordnet ist und unmittelbar auf der dielektrischen Materiallage (8) aufliegt.

## Beschreibung

Die Erfindung betrifft eine Anordnung für eine Halbleiteranordnung mit mindestens einem passiven Bauelement und einem Substrat, wobei das Substrat eine dielektrische Materiallage und eine auf der dielektrische Materiallage angeordnete erste Metallisierung aufweist.

Ferner betrifft die Erfindung eine Halbleiteranordnung, insbesondere eine planare Halbleiteranordnung, mit mindestens einer derartigen Anordnung.

Überdies betrifft die Erfindung einen Stromrichter mit mindestens einer Halbleiteranordnung.

Darüber hinaus betrifft die Erfindung ein Verfahren zur Herstellung einer Anordnung für eine Halbleiteranordnung mit mindestens einem passiven Bauelement und einem Substrat, wobei das Substrat eine dielektrische Materiallage und eine auf der dielektrischen Materiallage angeordnete erste Metallisierung aufweist.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. In einem Stromrichter können Bauelemente wie Kondensatoren, Snubber aber auch Sensoren, unter anderem zur Ermittlung von Strömen, Spannungen oder Temperaturen, zum Einsatz kommen, die üblicherweise auf einem Substrat aufgelötet sind. Derartige Sensoren können beispielsweise einen Strommesswiderstand, einen sogenannten Shunt-Widerstand oder einen Negative Temperature Coefficient Thermistor, kurz NTC, umfassen. Die Bauteile können teilweise, z.B. um genaue Messergebnisse zu erzielen, in einen stromführenden Pfad oder im Bereich einer Wärmequelle angeordnet werden, wobei eine ausreichende Entwärmung zu gewährleisten ist. Ferner stellen mit zunehmender Miniaturisierung der Bauraum und die Lebensdauer eine große Herausforderung dar.

Die Offenlegungsschrift EP 3 625 823 A1 beschreibt ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst. Um eine, im Vergleich zum Stand der Technik, höhere Beständigkeit gegenüber Feuchtigkeit zu erreichen und eine niederinduktive planare Anbindung des mindestens einen Leistungshalbleiters zu ermöglichen, wird vorgeschlagen, dass die erste Lage ein erstes dielektrisches Material mit zumindest einer ersten Metallisierung umfasst, wobei die erste Metallisierung auf einer der zweiten Lage zugewandten Seite angeordnet ist, wobei die zweite Lage ein zweites dielektrisches Material mit zumindest einer zweiten Metallisierung umfasst, wobei die zweite Metallisierung auf einer der ersten Metallisierung abgewandten Seite angeordnet ist, wobei der Leistungshalbleiter über die erste Kontaktfläche mit der ersten Metallisierung verbunden ist, wobei der Leistungshalbleiter in einer ersten Aussparung der zweiten Lage angeordnet ist, wobei eine metallische erste Kapselung derartig angeordnet ist, dass der Leistungshalbleiter fluiddicht gekapselt ist und die zweite Kontaktfläche des Leistungshalbleiters über die erste Kapselung elektrisch leitend mit der zweiten Metallisierung verbunden ist.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet.

Vor diesem Hintergrund ist es eine Aufgabe der vorliegenden Erfindung, den Bauraum einer derartigen Anordnung zu verringern und eine verbesserte Entwärmung zu ermöglichen.

Diese Aufgabe wird bei einer Anordnung eingangs genannter Art dadurch gelöst, dass das passive Bauelement vollständig in einer Aussparung der ersten Metallisierung angeordnet ist und unmittelbar auf der dielektrischen Materiallage aufliegt.

Ferner wird die Aufgabe erfindungsgemäß gelöst durch eine Halbleiteranordnung, insbesondere eine planare Halbleiteranordnung, mit mindestens einer derartigen Anordnung.

Überdies wird die Aufgabe erfindungsgemäß gelöst durch einen Stromrichter mit mindestens einer Halbleiteranordnung.

Darüber hinaus wird die Aufgabe bei einem Verfahren eingangs genannter Art dadurch gelöst, dass das passive Bauelement vollständig und derartig in einer Aussparung der ersten Metallisierung angeordnet wird, dass das passive Bauelement unmittelbar auf der dielektrischen Materiallage aufliegt.

Die in Bezug auf die Anordnung nachstehend angeführten Vorteile und bevorzugten Ausgestaltungen lassen sich sinngemäß auf die Halbleiteranordnung, den Stromrichter und das Verfahren übertragen.

Der Erfindung liegt die Überlegung zugrunde, den Bauraum mindestens eines passiven Bauelements in einer Anordnung für eine Halbleiteranordnung zu verringern, indem dieses vollständig in einer Aussparung einer ersten Metallisierung eines Substrats angeordnet wird. Eine Aussparung ist in diesem Zusammenhang eine durchgängige Ausnehmung der ersten Metallisierung. Diese durchgängige Ausnehmung kann unter anderem eine rechteckige Außenkontur aufweisen. Eine Halbleiteranordnung kann unter anderem ein Leistungshalbleitermodul sein. Ein derartiges, insbesondere zumindest teilweise metallisches, passives Bauelement kann unter anderem als Widerstandssensor, insbesondere als Shunt-Widerstand oder als NTC ausgeführt sein. Beispielsweise ist ein derartiger Widerstandssensor zumindest teilweise aus einer Legierung hergestellt, welche unter anderem Zeranin, Manganin, Konstantan, Isaohm oder einen Kaltleiter wie Platin enthalten kann. Die erste Metallisierung des Substrats kann beispielsweise Kupfer, Silber oder Gold enthalten. Durch eine derartige Integration des passiven Bauelements in die erste Metallisierung wird Bauraum, insbesondere in vertikale Richtung, eingespart.

Um eine ausreichende thermische Anbindung und damit eine effiziente Entwärmung des mindestens einen passiven Bauelements zu ermöglichen, liegt dieses unmittelbar, das heißt ohne weitere Verbindungsmittel, auf der dielektrischen Materiallage des Substrats auf. Die dielektrische Materiallage kann unter anderem einen keramischen Werkstoff, beispielsweise Aluminiumnitrid oder Aluminiumoxid, oder einen organischen Werkstoff, beispielsweise ein Polyamid oder Epoxidharz, enthalten. Insbesondere ist das, beispielsweise im wesentlichen quaderförmige, passive Bauelement vollflächig an die dielektrische Materiallage angebunden. Durch eine derartige Anbindung neben einer verbesserten Entwärmung zusätzlich Bauraum eingespart, da, unter anderem, weitere Bauteile näher am passiven Bauelement platzierbar sind. Ferner wird durch die Integration des mindestens einen passiven Bauelements das Herstellungsverfahren vereinfacht, da ein Bestückprozess und ein Auflöten entfällt.

Eine weitere Ausführungsform sieht vor, dass das passive Bauelement bündig mit einer ersten Oberfläche der ersten Metallisierung abschließt. Durch einen derartigen bündigen Abschluss wird ein Anpressen der ersten Metallisierung mit dem passive Bauelement erleichtert, sodass das passive Bauelement zuverlässig vollflächig mit der dielektrischen Materiallage kontaktierbar ist.

Eine weitere Ausführungsform sieht vor, dass die erste Metallisierung als Dickkupfersubstrat ausgeführt ist, wobei das passive Bauelement zwischen zwei Seiten des Dickkupfersubstrats vollflächig mit der dielektrischen Materiallage verpresst ist. Ein derartiges Dickkupfersubstrat weist eine Kupferdicke von mindestens 1 mm auf. Eine derartige Verbindung ist robust und einfach herstellbar.

Eine weitere Ausführungsform sieht vor, dass das passive Bauelement unmittelbar oder über Verbindungsmittel in der Aussparung der ersten Metallisierung verbunden ist. Eine unmittelbare Verbindung ist beispielsweise durch direktes Verpressen oder durch eine Schrumpfverbindung herstellbar. Mittels der Verbindungsmittel wird beispielsweise eine Pressfit-Verbindung hergestellt, über welche das das passiven Bauelement mit der ersten Metallisierung verbunden wird. Derartige kraftschlüssige Verbindungen sind robust und einfach herstellbar.

Eine weitere Ausführungsform sieht vor, dass das passive Bauelement aus einem ersten Werkstoff hergestellt ist, wobei die Verbindungsmittel einen zweiten Werkstoff enthalten, welcher sich vom ersten Werkstoff zumindest hinsichtlich seiner mechanischen und/oder thermischen Eigenschaften unterscheidet. Verbindungsmittel können beispielsweise Zinnplättchen oder eine Beschichtung des passiven Bauelements sein, welche beispielsweise Kupfer-Zinn (Cu-Sn), Kupfer-Nickel-Silizium (Cu-Ni-Si) oder Kupfer-Chrom-Silber (Cu-Cr-Ag) enthält. Durch unterschiedliche mechanische und/oder thermische Eigenschaften, wie Ausdehnungskoeffizient und/oder Elastizitätsmodul, werden beispielsweise während des Betriebes auftretende thermische Verspannungen verringert. Alternativ ist über die Verbindungsmittel eine stoffschlüssige Verbindung zwischen dem passiven Bauelement und der ersten Metallisierung herstellbar. Beispielsweise wird ein Zinnplättchen zur Herstellung einer stoffschlüssigen Verbindung geschmolzen. Derartige Verbindungen tragen durch Reduzierung von, insbesondere thermischen, Verspannungen, zu einer Verlängerung einer Lebensdauer der Anordnung bei.

Eine weitere Ausführungsform sieht vor, dass das passive Bauelement eine erste Profilierung und die erste Metallisierung im Bereich der Kontaktierung mit dem passiven Bauelement eine zweite Profilierung aufweist, wobei die Profilierungen miteinander im Eingriff stehen. Beispielsweise weist die erste Metallisierung eine Ausnehmung, insbesondere ein Falz oder/oder eine Fase auf, welche mit einem zumindest teilweise korrespondierenden Überstand des passiven Bauelements in Eingriff steht, wodurch ein Formschluss ausgebildet wird. Durch einen derartigen Formschluss wird die Zuverlässigkeit der Verbindung erhöht.

Eine weitere Ausführungsform sieht vor, dass das passive Bauelement über eine durch die formschlüssige Verbindung senkrecht zur ersten Oberfläche wirkende Kraft mit der dielektrischen Materiallage verbunden ist. Durch eine derartige Verbindung werden auf das passive Bauelement wirkende Verspannungen reduziert.

Eine weitere Ausführungsform sieht vor, dass das Substrat eine zweite Metallisierung aufweist, welche als Dickkupfersubstrat ausgeführt ist, wobei die dielektrische Materiallage auf die zweite Metallisierung laminiert oder mit der zweiten Metallisierung verpresst ist, wobei die zweite Metallisierung über die dielektrische Materiallage mit der ersten Metallisierung verbunden ist. Durch ein derartiges Herstellungsverfahren wird die Herstellung einer sehr dünnen Substratlage ermöglicht, was eine Wärmeabfuhr über die zweite Metallisierung verbessert.

Eine weitere Ausführungsform sieht vor, dass das passive Bauelement als Sensor ausgeführt ist und die Anordnung zumindest einen Anschluss zur Kontaktierung des Sensors umfasst. Beispielsweise ist der Sensor als Shunt-Widerstand ausgeführt, welcher Zeranin, Manganin, Konstantan, Isaohm enthält. Eine Integration eines derartigen Shunt-Widerstands verbessert die thermische Anbindung, sodass eine hohe Messgenauigkeit und lange Lebensdauer erzielbar sind. Alternativ kann der Sensor als Temperatursensor, z.B. als NTC, ausgeführt sein, welcher einen Kaltleiter, insbesondere Platin, enthält. Durch eine Verbesserung der thermischen Anbindung an die Umgebung über das Substrat wird eine genaue Temperaturerfassung ermöglicht.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Anordnung mit einem passiven Bauelement und einem Substrat,
- FIG 2: eine schematische Querschnittsdarstellung einer zweiten Ausführungsform einer Anordnung mit einem passiven Bauelement und einem Substrat,
- FIG 3: eine schematische Querschnittsdarstellung einer dritten Ausführungsform einer Anordnung mit einem passiven Bauelement und einem Substrat,
- FIG 4: eine schematische Querschnittsdarstellung einer vierten Ausführungsform einer Anordnung mit einem passiven Bauelement und einem Substrat,
- FIG 5: eine schematische Querschnittsdarstellung einer fünften Ausführungsform einer Anordnung mit einem passiven Bauelement und einem Substrat,
- FIG 6: eine schematische Darstellung eines Ausschnitts sechsten Ausführungsform einer Anordnung mit einem passiven Bauelement und einem Substrat in einer Draufsicht,
- FIG 7: eine schematische Darstellung eines Ausschnitts einer siebten Ausführungsform einer Anordnung mit einem passiven Bauelement und einem Substrat in einer Draufsicht,
- FIG 8: eine schematische Darstellung eines ersten Verfahrens zur Herstellung einer Anordnung mit einem passiven Bauelement und einem Substrat,
- FIG 9: eine schematische Darstellung eines zweiten Verfahrens zur Herstellung einer Anordnung mit einem passiven Bauelement und einem Substrat,
- FIG 10: eine schematische Darstellung eines dritten Verfahrens zur Herstellung einer Anordnung mit einem passiven Bauelement und einem Substrat,
- FIG 11: eine schematische Querschnittsdarstellung einer Halbleiteranordnung und
- FIG 12: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

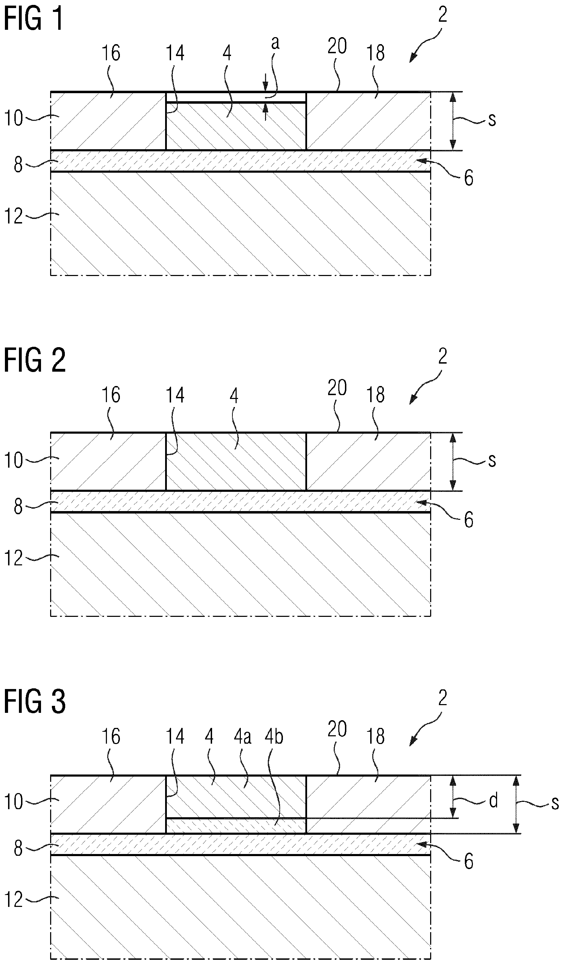

FIG 1 zeigt eine schematische Querschnittsdarstellung einer ersten Ausführungsform einer Anordnung 2 mit einem passiven Bauelement 4 und einem Substrat 6. Das Substrat 6 umfasst eine dielektrische Materiallage 8, welche zwischen einer ersten Metallisierung 10 und einer zweiten Metallisierung 12 angeordnet ist, wobei die erste Metallisierung 10 über die dielektrische Materiallage 8 mit der zweiten Metallisierung 12 elektrisch isolierend und thermisch leitend verbunden ist. Die dielektrische Materiallage 8 kann unter anderem einen keramischen Werkstoff, beispielsweise Aluminiumnitrid oder Aluminiumoxid, einen organischen Werkstoff, beispielsweise ein Polyamid, oder einen mit einem keramischen Werkstoff gefüllten organischen Werkstoff, enthalten. Die erste Metallisierung 10 und die zweite Metallisierung 12 sind beispielhaft als Dickkupfersubstrat mit einer Stärke s von zumindest 1 mm ausgeführt. Die erste Metallisierung 10 weist eine bis zur Aussparung 14 auf, in welcher das passive Bauelement 4 angeordnet ist. Das passive Bauelement 4 ist vollständig in der Aussparung 14 angeordnet, das heißt es steht nicht über die Aussparung 14 hinaus. Das, insbesondere metallische, passive Bauelement 4 kann unter anderem als Widerstandssensor, insbesondere als Shunt-Widerstand oder als NTC ausgeführt sein. Beispielsweise ist ein derartiger Widerstandssensor aus einer Legierung hergestellt, welche unter anderem Zeranin, Manganin, Konstantan, Isaohm oder einen Kaltleiter wie Platin enthalten kann.

Die Aussparung 14 der ersten Metallisierung 10 ist als eine bis zur dielektrischen Materiallage 8 durchgängige Ausnehmung ausgeführt. Das passive Bauelement 4, welches in FIG 1 im Wesentlichen quaderförmig ausgeführt ist, ist unmittelbar, das heißt ohne weitere Verbindungsmittel, zwischen einer ersten Seite 16 und einer zweiten Seite 18 des Dickkupfersubstrats verbunden. Beispielsweise ist das passive Bauelement 4, insbesondere durch direktes Verpressen oder durch eine Schrumpfverbindung, kraftschlüssig mit dem Dickkupfersubstrat verbunden. Ferner ist das mit dem Dickkupfersubstrat verbundene passive Bauelement 4 vollflächig mit der dielektrischen Materiallage 8 verpresst, wobei das passive Bauelement 4 unmittelbar vollflächig auf der dielektrischen Materiallage 8 aufliegt und somit elektrisch isolierend und thermisch leitend mit der zweiten Metallisierung 12 verbunden ist. Demnach ist im passiven Bauelement 4 entstehende Wärme über die dielektrischen Materiallage 8 abführbar. Darüber hinaus ist eine gute thermische Verbindung zu benachbarten Bauelementen, wie beispielsweise einem Leistungshalbleiterbauelement, herstellbar. Ferner schließt das passive Bauelement 4 mit einem Abstand a, welcher beispielsweise im pm-Bereich liegt, unterhalb einer ersten Oberfläche 20 der ersten Metallisierung 10 ab, wobei die erste Oberfläche 20 der ersten Metallisierung 10 eine horizontale Ebene definiert. Das passive Bauelement 4 ist also in das Substrat 6 integriert angeordnet, sodass Bauraum in vertikale Richtung eingespart wird.

FIG 2 zeigt eine schematische Querschnittsdarstellung einer zweiten Ausführungsform einer Anordnung 2 mit einem passiven Bauelement 4 und einem Substrat 6, wobei das in der Aussparung 14 der ersten Metallisierung 10 angeordnete, insbesondere kraftschlüssig verbundene, passive Bauelement 4 bündig mit der ersten Oberfläche 20 der ersten Metallisierung 10 abschließt. Das passive Bauelement 4 ist in das Substrat 6 integriert angeordnet, wobei Bauraum in vertikale Richtung eingespart wird. Ferner wird durch das bündige Abschließen Anpressen der ersten Metallisierung 10 mit dem passive Bauelement 4 erleichtert, sodass das passive Bauelement 4 zuverlässig vollflächig mit der dielektrischen Materiallage 8 kontaktierbar ist. Die weitere Ausführung der Anordnung 2 in FIG 2 entspricht der in FIG 1.

FIG 3 zeigt eine schematische Querschnittsdarstellung einer dritten Ausführungsform einer Anordnung mit einem passiven Bauelement 4 und einem Substrat 6. Das passive Bauelement 4 umfasst eine metallische Schicht 4a und eine auf einer der dielektrischen Materiallage 8 zugewandten Seite der metallischen Schicht 4a angeordnete dielektrische Schicht 4b. Die dielektrische Schicht 4b ist elektrisch isolierend ausgeführt und kann unter anderem einen organischen Werkstoff, insbesondere einen Kunststoff, oder einen keramischen Werkstoff enthalten. Durch die dielektrische Schicht 4b wird eine thermisch leitfähige Anbindung der metallischen Schicht 4a des passiven Bauelements 4 an die dielektrischen Materiallage 8 ermöglicht. Unter anderem durch Variation einer Dicke d der metallischen Schicht 4a ist ein Widerstandswert des bündig mit der ersten Oberfläche 20 der ersten Metallisierung 10 abschließenden passiven Bauelements 4 flexibel einstellbar. Die weitere Ausführung der Anordnung 2 in FIG 3 entspricht der in FIG 2.

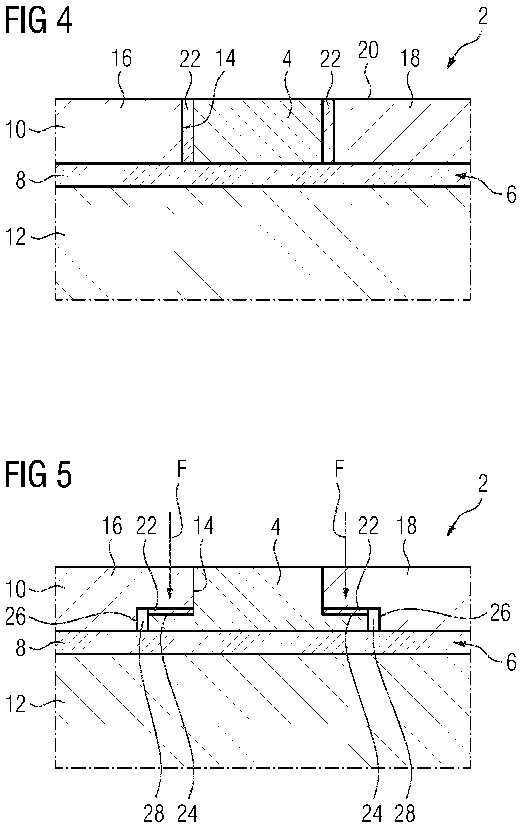

FIG 4 zeigt eine schematische Querschnittsdarstellung einer vierten Ausführungsform einer Anordnung 2 mit einem passiven Bauelement 4 und einem Substrat 6, wobei das passive Bauelement 4 beidseitig über Verbindungsmittel 22 in der Aussparung 14 der ersten Metallisierung 10 verbunden ist. Die Verbindungsmittel 22 sind beispielsweise Zinnplättchen. Alternativ können die Verbindungsmittel 22 eine Beschichtung, insbesondere des passiven Bauelements 4, sein, welche beispielsweise Kupfer-Zinn (Cu-Sn), Kupfer-Nickel-Silizium (Cu-Ni-Si) oder Kupfer-Chrom-Silber (Cu-Cr-Ag) enthält. Mittels der Verbindungsmittel 22 wird eine Pressfit-Verbindung hergestellt, über welche das das passiven Bauelement 4 mit der ersten Metallisierung 10 verbunden wird. Durch unterschiedliche mechanische und/oder thermische Eigenschaften, wie Ausdehnungskoeffizient und/oder Elastizitätsmodul, werden beispielsweise während des Betriebes auftretende thermische Verspannungen verringert. Alternativ wird über die Verbindungsmittel 22 eine stoffschlüssige Verbindung zwischen dem passiven Bauelement 4 und der ersten Metallisierung 10 hergestellt. Die weitere Ausführung der Anordnung 2 in FIG 4 entspricht der in FIG 3.

FIG 5 zeigt eine schematische Querschnittsdarstellung einer fünften Ausführungsform einer Anordnung 2 mit einem passiven Bauelement 4 und einem Substrat 6, wobei das passive Bauelement 4 beidseitig jeweils eine erste Profilierung 24 und die erste Metallisierung 10 im Bereich der Kontaktierung mit dem passiven Bauelement 4 jeweils eine zweite Profilierung 26 aufweist. Beispielhaft weist die erste Metallisierung 10 eine Ausnehmung in Form einer Falz auf, wobei das passive Bauelement 4 einen Überstand aufweist, welcher mit der Ausnehmung der ersten Metallisierung 10 in Eingriff steht. Durch die miteinander ein Eingriff stehenden Profilierungen 22, 24 wird eine formschlüssige Verbindung ausgebildet. Zusätzlich oder alternativ weisen die Profilierungen 22, 24 jeweils eine Fase auf. Auf einer der dielektrischen Materiallage 8 abgewandten Seite des Überstands sind jeweils Verbindungsmittel 22, insbesondere Zinnplättchen, angeordnet, welche das passive Bauelement 4 mit der ersten Metallisierung 10 verbinden. Weist die Anordnung 2 Ausgleichsstrukturen 28 zur Kompensation von, insbesondere thermisch bedingten, Ausdehnungen auf. Somit ist das passive Bauelement 4 über eine durch die formschlüssige Verbindung senkrecht zur ersten Oberfläche 20 wirkende Kraft F mit der dielektrischen Materiallage 8 verbunden. Die weitere Ausführung der Anordnung 2 in FIG 5 entspricht der in FIG 4.

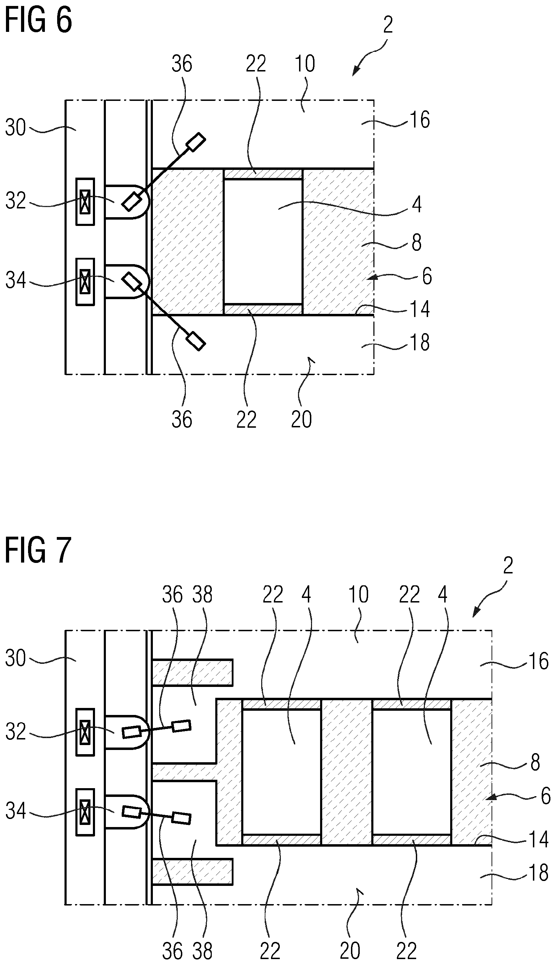

FIG 6 zeigt eine schematische Darstellung eines Ausschnitts einer sechsten Ausführungsform einer Anordnung 2 mit einem passiven Bauelement 4 und einem Substrat 6 in einer Draufsicht. Die Anordnung 2 ist in einem Gehäuse 30 angeordnet und umfasst Anschlüsse 32, 34 zur Kontaktierung des passiven Bauelements 4. Die Anschlüsse 32, 34 sind beispielhaft als Gehäusepins ausgeführt, welche über Bondverbindungsmittel 36, insbesondere Bonddrähte, mit jeweils einer Seite 16, 18 der ersten Metallisierung 10 verbunden sind. Somit wird das passive Bauelement 4 durch die Anschlüsse 32, 34 derartig kontaktiert, dass beispielsweise ein Ermitteln einer am passiven Bauelement 4 abfallenden Spannung oder eines durch das passive Bauelement 4 fließenden Stroms ermöglicht wird. Insbesondere ist das passive Bauelement 4 als NTC-Widerstand zur Verwendung als Temperatursensor ausgeführt, wobei der NTC-Widerstand Platin enthält. Die weitere Ausführung der Anordnung 2 in FIG 6 entspricht der in FIG 4.

FIG 7 zeigt eine schematische Darstellung eines Ausschnitts einer siebten Ausführungsform einer Anordnung mit einem passiven Bauelement und einem Substrat in einer Draufsicht, wobei beispielhaft zwei passive Bauelemente 4 parallelgeschaltet sind. Die passiven Bauelemente 4 sind beispielhaft als Shunt-Widerstände zur Messung eines Laststroms in einem Leistungshalbleitermodul ausgeführt und sind aus einer Legierung hergestellt, welche Zeranin, Manganin, Konstantan oder Isaohm enthält. Die erste Metallisierung 10 weist auf beiden Seite 16, 18 ein Kontaktpad 38 zur Kontaktierung der Anschlüsse 32, 34 auf. Die Anschlüsse 32, 34 werden über Bondverbindungsmittel 36, insbesondere Bonddrähte, mit den Kontaktpads 38 verbunden. Über die Anschlüsse 32, 34 wird ein Ermitteln eines Spannungsabfalls an den passiven Bauelementen 4, insbesondere zur Ermittlung eines Stromes, ermöglicht. Die weitere Ausführung der Anordnung 2 in FIG 7 entspricht der in FIG 6.

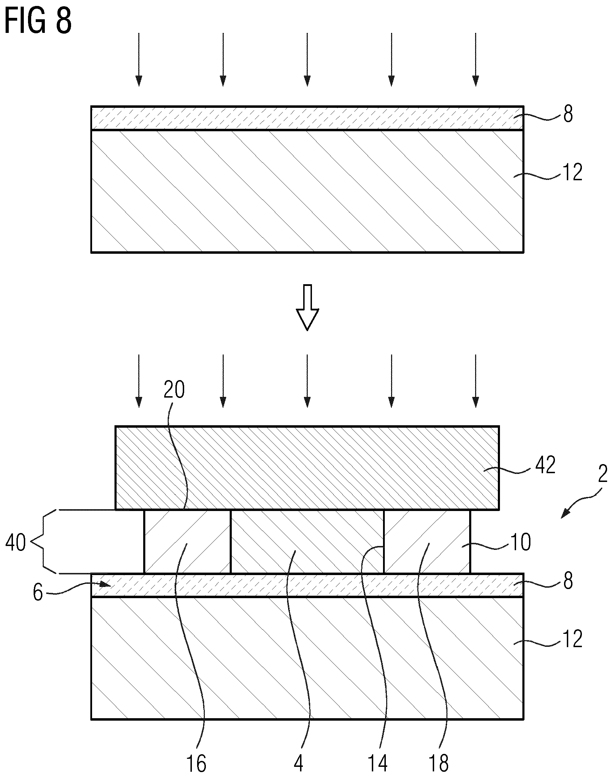

FIG 8 zeigt eine schematische Darstellung eines ersten Verfahrens zur Herstellung einer Anordnung 2 mit einem passiven Bauelement 4 und einem Substrat 6. Eine dielektrische Materiallage 8 wird auf eine zweite Metallisierung 12, welche als Dickkupfersubstrat ausgeführt ist, laminiert. Alternativ wird die dielektrische Materiallage 8 durch Verpressen mit der zweiten Metallisierung 12 verbunden.

In einem weiteren Schritt wird ein passive Bauelement 4 derartig in eine Kavität 44 einer als Dickkupfersubstrat ausgeführten ersten Metallisierung 10 eingebracht und zwischen zwei Seiten 16, 18 der ersten Metallisierung 10 zu einer Top-Lage 40 verbunden. Über eine Pressvorrichtung 42, beispielsweise einen, insbesondere ebenen, Pressstempel, wird die Top-Lage 40 mit der dielektrischen Materiallage 8 derartig verpresst, dass das passive Bauelement 4 vollflächig und unmittelbar auf der dielektrischen Materiallage 8 aufliegt und bündig mit einer ersten Oberfläche 20 der ersten Metallisierung 10 abschließt. Das Verbinden des passiven Bauelements 4 mit der ersten Metallisierung 10 und das Verpressen mit der dielektrischen Materiallage 8 durch die Pressvorrichtung 42 können gleichzeitig stattfinden. Die in FIG 8 gezeigten Schritte sind, insbesondere wenn das Dielektrikum nur einmal aushärtbar ist, in einem Pressvorgang durchführbar. Die weitere Ausführung der Anordnung 2 in FIG 8 entspricht der in FIG 2.

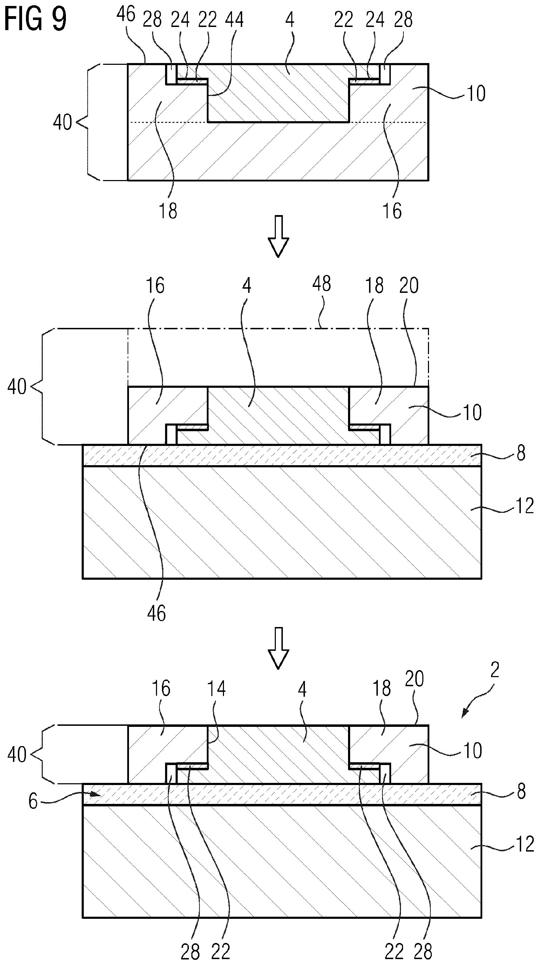

FIG 9 zeigt eine schematische Darstellung eines zweiten Verfahrens zur Herstellung einer Anordnung 2 mit einem passiven Bauelement 4 und einem Substrat 6, wobei das passive Bauelement 4 in eine Kavität 44 der als Dickkupfersubstrat ausgeführten ersten Metallisierung 10 eingebracht und mit der ersten Metallisierung 10 zu einer Top-Lage 40 verbunden wird. Die Kavität 44 der ersten Metallisierung 10 weist auf beiden Seiten 16, 18 eine Ausnehmung in Form einer Falz auf, wobei das passive Bauelement 4 einen Überstand aufweist, welcher mit der Ausnehmung der ersten Metallisierung 10 in Eingriff steht. Wie in FIG 5 gezeigt, ist das passive Bauelement 4 im Bereich seiner beidseitig angeordneten Überstände über Verbindungsmittel 22, insbesondere Zinnplättchen, mit der ersten Metallisierung 10 verbunden und die Anordnung 2 weist Ausgleichsstrukturen 28 zur Kompensation von, insbesondere thermisch bedingten, Ausdehnungen auf. Die Ausgleichsstrukturen 28 sind mit einem Füllmaterial, beispielsweise mit Silikon, gefüllt, um Teilentladungen zu verhindern. Das passive Bauelement 4 schließt bündig mit einer zweiten Oberfläche 46 der ersten Metallisierung 10 ab.

In einem weiteren Schritt wird die Top-Lage 40 über die zweite Oberfläche 46 mit der dielektrischen Materiallage 8 derartig verpresst, dass das passive Bauelement 4 unmittelbar auf der dielektrischen Materiallage 8 aufliegt.

In einem darauffolgenden Schritt wird eine auf einer dem passiven Bauelement 4 abgewandten Seite angeordnete Schicht 48 der ersten Metallisierung 10 mittels spanender Bearbeitung, z.B. durch Fräsen, derartig abgetragen, dass die Kavität 44 zu einer Aussparung 14 in der ersten Metallisierung 10 wird. Ferner wird durch das Abtragen der Schicht 48 das passive Bauelement 4 freigelegt, wobei das das passive Bauelement 4 bündig mit der ersten Oberfläche 20 der ersten Metallisierung 10 abschließt. Die weitere Ausführung der Anordnung 2 in FIG 9 entspricht der in FIG 5.

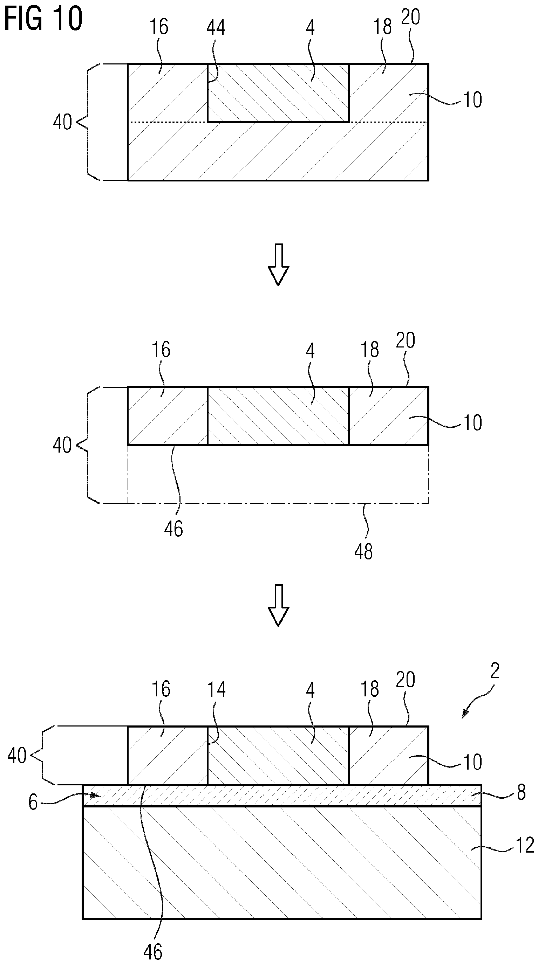

FIG 10 zeigt eine schematische Darstellung eines dritten Verfahrens zur Herstellung einer Anordnung 2 mit einem passiven Bauelement 4 und einem Substrat 6, wobei das passive Bauelement 4 in eine Kavität 44 der als Dickkupfersubstrat ausgeführten ersten Metallisierung 10 eingebracht und mit der ersten Metallisierung 10 zu einer Top-Lage 40 verbunden wird. Beispielsweise ist das passive Bauelement 4, insbesondere durch direktes Verpressen oder durch eine Schrumpfverbindung, kraftschlüssig mit dem Dickkupfersubstrat verbunden. Das passive Bauelement 4 schließt bündig mit der ersten Oberfläche 20 der ersten Metallisierung 10 ab.

In einem weiteren Schritt wird eine auf einer dem passiven Bauelement 4 abgewandten Seite angeordnete Schicht 48 der ersten Metallisierung 10, insbesondere mittels spanender Bearbeitung, derartig abgetragen, dass das passive Bauelement 4 freigelegt wird und das passive Bauelement 4 bündig mit einer zweiten Oberfläche 46 der ersten Metallisierung 10 abschließt.

In einem darauffolgenden Schritt wird der verbleibende Teil der Top-Lage 40 über die zweite Oberfläche 46 mit der dielektrischen Materiallage 8 derartig verpresst, dass das passive Bauelement 4 unmittelbar auf der dielektrischen Materiallage 8 aufliegt. Die weitere Ausführung der Anordnung 2 in FIG 9 entspricht der in FIG 5.

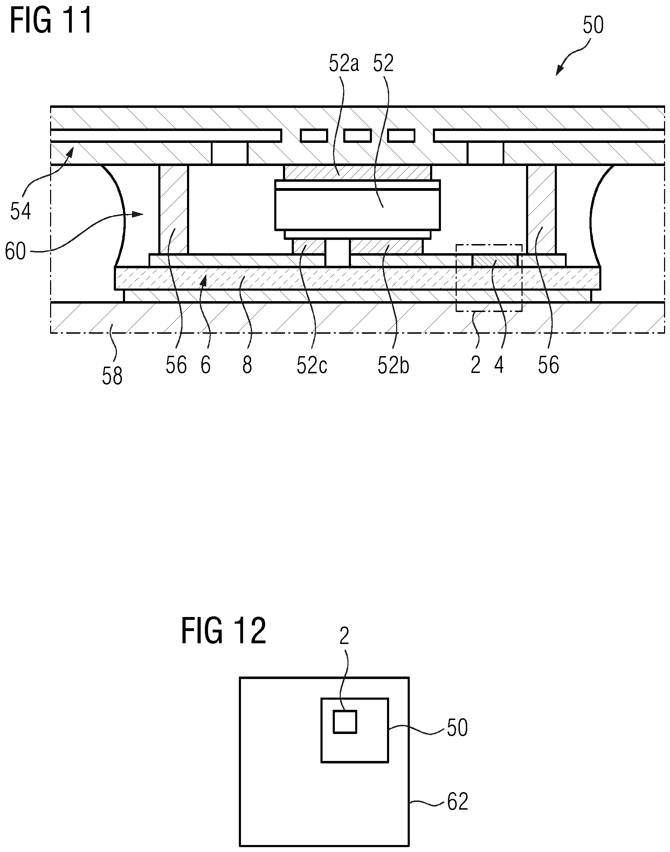

FIG 11 zeigt eine schematische Querschnittsdarstellung einer Halbleiteranordnung 50, welche ein Halbleiterbauelement 52 umfasst, dass mittels planarer Aufbau- und Verbindungstechnik realisiert ist. Das Halbleiterbauelement 52 ist beispielhaft als vertikaler Leistungstransistor, insbesondere als Insulated-Gate-Bipolar-Transistor (IGBT), ausgeführt. Der Leistungstransistor ist über einen ersten Leistungsanschluss 52a mit einer Leiterplatte 54, insbesondere einem Printed Circuit Board (PCB) verbunden. Auf einer dem ersten Leistungsanschluss 52a gegenüberliegenden Seite ist der Leistungstransistor über einen zweiten Leistungsanschluss 52b und einen Steueranschluss 52c mit einem Substrat 6 verbunden, das als DCB-Substrat ausgeführt ist. Über Abstandshalteelemente 56, auch Umsteiger genannt, werden der zweite Leistungsanschluss 52b und der Steueranschluss 52c elektrisch leitend mit der Leiterplatte 54 verbunden. Ferner weist die Halbleiteranordnung 50 eine Anordnung 2 mit einem passives Bauelement 4 auf, welche nach einer der vorherigen Figuren ausgeführt sein kann. Das passives Bauelement 4 ist beispielsweise dazu konfiguriert, einen Strom des zweiter Leistungsanschlusses 52b zu erfassen. Das Substrat 6 ist ferner mit einer Wärmesenke 58, beispielsweise einem Kühlkörper, verbunden, sodass das Halbleiterbauelement 52 und das passives Bauelement 4 elektrisch isolierend und thermisch leitend mit der Wärmesenke 58 verbunden sind. Zwischen der Leiterplatte 54 und dem Substrat 6 ist ein Vergussmaterial 60 angeordnet, in welchem das Halbleiterbauelement 52, die Abstandshalteelemente 56 sowie das das passives Bauelement 4 eingebettet sind. Das Vergussmaterial 60 ist beispielsweise mit Hilfe eines Underfillers gefertigt.

FIG 12 zeigt eine schematische Darstellung eines Stromrichters, welcher beispielhaft eine Halbleiteranordnung 50 mit einer Anordnung 2 umfasst.

Zusammenfassend betrifft die Erfindung eine Anordnung 2 für eine Halbleiteranordnung 50 mit mindestens einem passiven Bauelement 4 und einem Substrat 6, wobei das Substrat 6 eine dielektrische Materiallage 8 und eine auf der dielektrische Materiallage 8 angeordnete erste Metallisierung 10 aufweist. Um den Bauraum der Anordnung 2 zu verringern und eine verbesserte Entwärmung zu ermöglichen, wird vorgeschlagen, dass das passive Bauelement 4 vollständig in einer Aussparung 14 der ersten Metallisierung 10 angeordnet ist und unmittelbar auf der dielektrischen Materiallage 8 aufliegt.

## Patentansprüche

1. Anordnung (2) für eine Halbleiteranordnung (50) mit mindestens einem passiven Bauelement (4) und einem Substrat (6), wobei das Substrat (6) eine dielektrische Materiallage (8) und eine auf der dielektrische Materiallage (8) angeordnete erste Metallisierung (10) aufweist,
**dadurch gekennzeichnet, dass**
das passive Bauelement (4) vollständig in einer Aussparung (14) der ersten Metallisierung (10) angeordnet ist und unmittelbar auf der dielektrischen Materiallage (8) aufliegt.

2. Anordnung (2) nach Anspruch 1,
wobei das passive Bauelement (4) bündig mit einer ersten Oberfläche (20) der ersten Metallisierung (10) abschließt.

3. Anordnung (2) nach einem der Ansprüche 1 oder 2,
wobei die erste Metallisierung (10) als Dickkupfersubstrat ausgeführt ist,
wobei das passive Bauelement (4) zwischen zwei Seiten (16, 18) des Dickkupfersubstrats vollflächig mit der dielektrischen Materiallage (8) verpresst ist.

4. Anordnung (2) nach einem der vorherigen Ansprüche,
wobei das passive Bauelement (4) unmittelbar oder über Verbindungsmittel (22) in der Aussparung (14) der ersten Metallisierung (10) verbunden ist.

5. Anordnung (2) nach Anspruch 4,
wobei das passive Bauelement (4) aus einem ersten Werkstoff hergestellt ist,
wobei die Verbindungsmittel (22) einen zweiten Werkstoff enthalten, welcher sich vom ersten Werkstoff zumindest hinsichtlich seiner mechanischen und/oder thermischen Eigenschaften unterscheidet.

6. Anordnung (2) nach einem der vorherigen Ansprüche,
wobei das passive Bauelement (4) eine erste Profilierung (24) und die erste Metallisierung (10) im Bereich der Kontaktierung mit dem passiven Bauelement (4) eine zweite Profilierung (24) aufweist,
wobei die Profilierungen (24, 26) miteinander im Eingriff stehen.

7. Anordnung (2) nach Anspruch 6,
wobei das passive Bauelement (4) über eine durch die formschlüssige Verbindung senkrecht zur ersten Oberfläche (20) wirkende Kraft (F) mit der dielektrischen Materiallage (8) verbunden ist.

8. Anordnung (2) nach einem der vorherigen Ansprüche,
wobei das Substrat (6) eine zweite Metallisierung (12) aufweist, welche als Dickkupfersubstrat ausgeführt ist,
wobei die dielektrische Materiallage (8) auf die zweite Metallisierung (12) laminiert oder mit der zweiten Metallisierung (12) verpresst ist,
wobei die zweite Metallisierung (12) über die dielektrische Materiallage (8) mit der ersten Metallisierung (10) verbunden ist.

9. Anordnung (2) nach einem der vorherigen Ansprüche, welche das passive Bauelement (4) als Sensor ausgeführt ist und
wobei die Anordnung (2) zumindest einen Anschluss (32, 34) zur Kontaktierung des Sensors umfasst.

10. Halbleiteranordnung (50), insbesondere planare Halbleiteranordnung, mit mindestens einer Anordnung (2) nach einem der vorherigen Ansprüche.

11. Stromrichter (62) mit mindestens einer Halbleiteranordnung (50) nach dem vorherigen Anspruch.

12. Verfahren zur Herstellung einer Anordnung (2) für eine Halbleiteranordnung (50) mit mindestens einem passiven Bauelement (4) und einem Substrat (6),
wobei das Substrat (6) eine dielektrische Materiallage (8) und eine auf der dielektrische Materiallage (8) angeordnete erste Metallisierung (10) aufweist,
**dadurch gekennzeichnet, dass**
das passive Bauelement (4) vollständig und derartig in einer Aussparung (14) der ersten Metallisierung (10) angeordnet wird, dass das passive Bauelement (4) unmittelbar auf der dielektrischen Materiallage (10) aufliegt.

13. Verfahren nach Anspruch 12,
wobei das passive Bauelement (4) derartig in der Aussparung (14) angeordnet wird, dass es bündig mit einer ersten Oberfläche (20) der ersten Metallisierung (10) abschließt.

14. Verfahren nach einem der Ansprüche 12 oder 13,
wobei die erste Metallisierung (10) als Dickkupfersubstrat ausgeführt ist,
wobei das passive Bauelement (4) zwischen zwei Seiten (16, 18) des Dickkupfersubstrats vollflächig mit der dielektrischen Materiallage (8) verpresst wird.

15. Verfahren nach einem der Ansprüche 12 bis 14,
wobei das passive Bauelement (4) unmittelbar oder über Verbindungsmittel (22) in der Aussparung (14) der ersten Metallisierung (10) verbunden wird.

16. Verfahren nach einem der Ansprüche 12 bis 15,
wobei das passive Bauelement (4) eine erste Profilierung (24) und die erste Metallisierung (10) im Bereich der Kontaktierung mit dem passiven Bauelement (4) eine zweite Profilierung (26) aufweist,
wobei durch die Profilierungen (24, 26) miteinander im Eingriff gebracht werden.

17. Verfahren nach einem der Ansprüche 12 bis 16,
wobei das passive Bauelement (4) in eine Kavität (44) der als Dickkupfersubstrat ausgeführten ersten Metallisierung (10) eingebracht und mit der ersten Metallisierung (10) zu einer Top-Lage (40) verbunden wird,
wobei die Top-Lage (40) mit der dielektrischen Materiallage (8) derartig verpresst wird, dass das passive Bauelement (4) unmittelbar auf der dielektrischen Materiallage (8) aufliegt,
wobei eine auf einer dem passiven Bauelement (4) abgewandten Seite angeordnete Schicht (48) der ersten Metallisierung (10), insbesondere mittels spanender Bearbeitung, derartig abgetragen wird, dass das passive Bauelement (4) freigelegt wird und bündig mit einer ersten Oberfläche (20) der ersten Metallisierung (10) abschließt.

18. Verfahren nach einem der Ansprüche 12 bis 16,
wobei das passive Bauelement (4) derartig in eine Kavität (44) der als Dickkupfersubstrat ausgeführten ersten Metallisierung (10) eingebracht und mit der ersten Metallisierung (10) zu einer Top-Lage (40) verbunden wird, dass das passive Bauelement (4) bündig mit einer ersten Oberfläche (20) der ersten Metallisierung (10) abschließt,
wobei eine auf einer dem passiven Bauelement (4) abgewandten Seite angeordnete Schicht (48) der ersten Metallisierung (10), insbesondere mittels spanender Bearbeitung, derartig abgetragen wird, dass das passive Bauelement (4) freigelegt wird und das passive Bauelement (4) bündig mit einer zweiten Oberfläche (46) der ersten Metallisierung (10) abschließt,
wobei die Top-Lage (40) mit der dielektrischen Materiallage (8) derartig verpresst wird, dass das passive Bauelement (4) unmittelbar auf der dielektrischen Materiallage (8) aufliegt.

19. Verfahren nach einem der Ansprüche 12 bis 18,
wobei das Substrat (6) eine zweite Metallisierung (12) aufweist, welche als Dickkupfersubstrat ausgeführt ist,
wobei die dielektrische Materiallage (8) auf die zweite Metallisierung (12) laminiert oder mit der zweiten Metallisierung (12) verpresst wird.
